# EUROPEAN PATENT APPLICATION

(11) **EP 2 618 645 A1**
(43) Date of publication of application: **24.07.2013**
(21) Application number: 12290025.1
(22) Date of filing: 19.01.2012
(51) Int. Cl.: H05K 7/20

(54) **Thermal management of electronics and photonics equipment**

(71) Applicant: Alcatel Lucent, 75007 Paris (FR)
(72) Inventor: Hernon, Domhnaill, Bettystown, County Meath (IE); Daly, John, Tralee, County Kerry (IE); Jeffers, Nicholas, Delgany, County Wicklow (IE)
(74) Representative: Lupton, Frederick

(57) **Abstract**

For thermal management of electronics and/or photonics equipment, comprising one or more circuit packs that include a plurality of devices (30) that get significantly hotter in operation than other components, a source of compressed air is coupled (22) to a fluid distribution arrangement which includes a manifold having a plurality of outlets (26) which are arranged so as to direct a respective jet of cold air at each of the devices, and wherein each outlet has an associated flap (28) of, for example memory shape alloy, responsive to change in temperature of the respective device, whereby to open the fluid outlet to permit flow of the respective jet with a rise in temperature of the respective device.

## Description

### Field of the Invention

The present invention relates to thermal management of equipment that includes electronics circuits and/or photonics circuits, which are contained in circuit packs.

### Background Art

For the purposes of the present specification, the term "circuit pack" will be understood to include circuit boards, cards and blades, mounting photonic or electronic components.

Thermal management is becoming a key issue in operation of telecommunications equipment. In the past the main role of thermal management was to maintain components at or below a critical junction temperature in order to ensure reliability; however, thermal management is now a critical step in the design process because it occupies a dual role of enabling enhanced functionality while at the same time reducing power consumption and hence carbon footprint. The next generation of telecommunications products will have significantly increased power dissipation due to their enhanced functionality.

For example, a next generation telecommunications circuit pack may dissipate more than 300W with more than 50% of this power concentrated on only two computing processor devices. One solution to the problem is to attach a respective heat sink to each hot processor device and then pass airflow over this via many cooling fans. In the past the heat sinks were typically manufactured from aluminum which has poor thermal conductivity. It is now the situation that the heat sinks are manufactured out of copper. Copper has twice the thermal conductivity of aluminum; however, copper is more expensive. But pure copper heat sinks do not supply adequate cooling for high power components. The base of the heat sink might contain sealed heat pipes containing fluid at low pressure, which boils to absorb heat; but even this measure may be insufficient.

Furthermore, in order to supply adequate cooling of such circuit packs, air cooling fans must be operated at increased speed and hence power. Operating the fans like this reduces the fan reliability, and increases the acoustic noise above the (NEBS or ETSI) regulated levels; the increased audible noise emissions from such a solution would render the product useless due to breach of the noise regulations. Further the fans on circuit packs such as described above, have to operate at high power in order to provide adequate cooling to just a couple of critically hot processor components. This implies overcooling of other components in the pack and is hence wasteful of energy. Another issue is that cooling fans may not be completely reliable.

Another example of a next generation product suffering from thermal design issues is a circuit pack containing photonics equipment which may dissipate more than 300W. A main cooling problem is that as many as 16 XFPs (transceivers for computing equipment using optical fiber) can be placed in-line placed directly adjacent one another in line, and in close proximity and each dissipating 3.5W. This leads to significant upstream heating effects. The maximum temperature predicted on such XFPs is far higher than can be accommodated with existing thermal management solutions. The best current solution is to place individual heat sinks on each XFP. Due to the size of the XFP there is little available space for the extra height on the XFP heat sink and this reduces the effectiveness of the XFP heat sinks. Also, because each XFP has its own individual heat sink, this implies that there is wasted space in between each XFP where extra heat transfer surface material could be utilized.

### Summary of the Invention

Various embodiments provide thermal management apparatus for electronics and/or photonics equipment, the equipment comprising one or more circuit packs that include a plurality of devices that have different heating characteristics than other components of said one or more circuit packs, the thermal management apparatus comprising a source of fluid, and a fluid distribution arrangement coupled to said source, and including a manifold having a plurality of outlets which are arranged so as to direct a respective jet of fluid towards each of said devices,
and wherein each said outlet has an associated closure means responsive to change in temperature of the respective device, whereby said closure means is moved from a position in which said outlet is closed to a position in which said outlet is open, in response to a rise in temperature of the respective device.

In common circumstances, said devices will generate significantly more heat than other components in the pack or packs, for example they may be processor devices or XFPs as mentioned above, and hence use of a cooling fluid will avoid the necessity for excessive fan air cooling. However said devices may include any device that has differing heating characteristics from other components in the pack or packs, and which may be at risk of overheating, no matter how much heat it generates. Clearly, if all components of the circuit pack(s) have precisely the same heating characteristics, there may be little benefit in employing an embodiment of the invention.

In usual circumstances, there will be a one to one correspondence between the number of devices for which specific cooling is required, and the number of jets, each jet being aimed towards a respective device. However in some circumstances there may not be a precise one to one correspondence. For example a single jet of cooling fluid may be sufficient for cooling more than one device, within the trajectory of the jet, or perhaps it may not be necessary in some situations to cool one specific device. Alternatively, one or more devices may require more than one cooling jet for appropriate cooling.

Whilst the fluid will usually be compressed air, other fluids, such as pressurized dielectric fluid may be employed.

Each circuit pack may be mounted together with other packs in an array, and the array may be mounted in one or more racks or shelves, in one or more cabinets.

An embodiment provides supplementary or complete air cooling via a distribution arrangement comprising ducts connected to compressed air, a compressed air line being available in a datacenter or otherwise a small low-pressure compressor is attached to the side of a cabinet housing circuit pack racks. When the air is ejected from the ducts, it provides a high velocity jet of air which impinges on a hot device or associated heat sink thereby improving the heat transfer substantially. In order to generate an effective thermal network of air jets, a Boolean style thermal feedback jet is described herein. This system enables the thermal control of individual components.

The closure means for each said aperture might possibly be powered by an external source of energy and include a temperature sensor located adjacent the respective device, but for simplicity of implementation, it is preferred that the closure means derives its energy for operation from the heat generated by the associated hot device, by making a good thermal connection with the device, as by a metallic strap. The closure device might include a bimetallic element for initiating the required movement for closure of the aperture, as for example with a flap movable between a position in which it closes the aperture, and an open position. As preferred however the flap comprises a memory shape alloy such as Nitinol, which usually closes the aperture, but upon heating, assume a prestressed position in which it upstands vertically from a plate containing the aperture.

Whilst the closure means, for example employing bimetal or memory shape alloy may operate to open the respective aperture at a predetermined temperature, it is not necessary that operation should occur at a precisely determined temperature. All that is necessary is that operation should occur in response to a discernible change in temperature of the device, as evidenced for example by the quantity of heat being generated by the device and conducted to the closure means.

Compressors are more reliable than fans. Depending on the level of cooling required, the jets of air can be used in parallel with forced air cooling from fans. In the application mentioned above of a next generation telecommunications circuit pack, the overall fan power consumption could be greatly reduced as a jet or jets of compressed air would be focused on the hottest components. In the case of the other application mentioned above, a circuit pack containing photonics equipment, the air jets could be focused around the XFPs thereby providing adequate cooling.

One of the benefits of this approach is that if we target the most critical highest power components in a circuit pack, then we can reduce the overall requirement for system level cooling. Thus if system level fan speed is reduced by 50% 85% of the system level fan power can be saved. Considering that in a data centre there are hundreds of cabinets each of which have a multiple fan trays and each fan tray contains multiple fans, reducing the system level fan power consumption can lead to significant energy savings across the entire data centre. Furthermore, the use of temperature sense and control mechanism means that it may only be necessary to activate compressed air cooling in the most extreme of conditions, e.g. when the ambient air goes above a certain amount, e.g. 40°C. This would enable a cooling solution involving fans and heat sinks to meet the thermal requirements at 40°C and if the ambient air increases beyond 40°C then the compressed air cooling activated.

### Brief Description of the Drawings

A preferred embodiment of the invention will now be described, by way of example only, with reference to the accompanying drawings, wherein:
Figure 1 is an explanatory sketch for the purpose of understanding the present invention, illustrating compressed air impinging on a heat sink;
Figure 2 is an explanatory sketch similar to Figure 1 except the heat sink is removed, to illustrate the possibility of reducing costs by cooling the package or the bare die without the need for a heat sink;
Figure 3 comprises perspective views of a fluid distribution manifold forming an embodiment of the invention, providing four Boolean thermal feedback jets impinging on four heat dissipating components: Figure 3(A) shows the manifold which is connected to an air supply line at the inlet; Figure 3(B) shows an exploded view of the manifold; and Figure 3(C) illustrates a thermal connection between Nitinol flaps and the components to be cooled; and
Figure 4 is a diagram of a rack of circuit packs with hot components which may or may not have heat sinks attached. Localized cooling is achieved by air jets from the compressed air line which supplements the main airflow from the fans.

### Description of the Embodiment

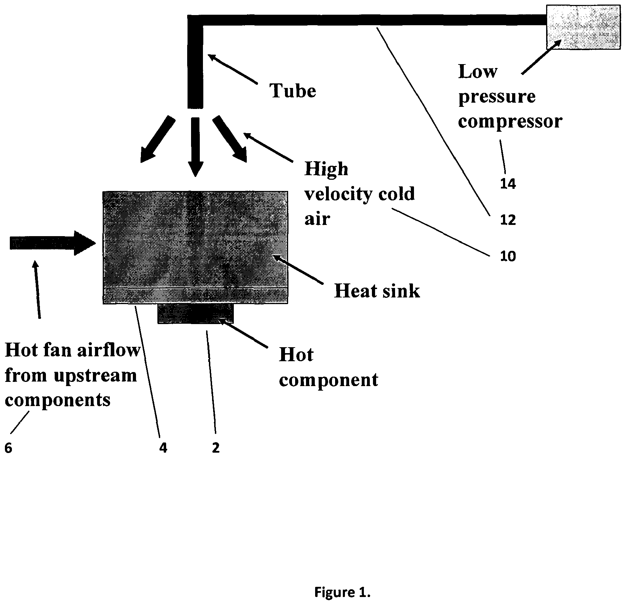

Figure 1 is an explanatory sketch for the purpose of understanding the present invention. In the Figure a component 2 that becomes very hot in operation is coupled to a heat sink 4. Fan airflow is provided at 6, but since this is already hot from upstream components and upstream racks of equipment, its cooling effect on component 2 is weakened owing to upstream heating. Heat sink 4 is cooled by an impinging jet of air 10 that ejects out of a tube 12 which is attached to a cooling fluid line, e.g. compressed air line or compressor 14. Note that the orientation of the tube to the heat sink need not be limited to that shown. Compressed air may be supplied by a compressed air line in a data centre or by a small low pressure compressor as shown. In the example shown in Figure 1, the upstream airflow supplied by the fans is heated owing to the fact that it has just passed over many hot components from upstream shelves or racks in the cabinet. Because the upstream fan airflow is heated, this implies that the fan must operate at increased airflow rate and hence increased power in order to adequately cool the components. In order to alleviate the burden on the fans, supplementary local air cooling is supplied by the jet of air from the tube. It must be noted that the tube can be oriented at any angle that is deemed adequate to provide cooling.

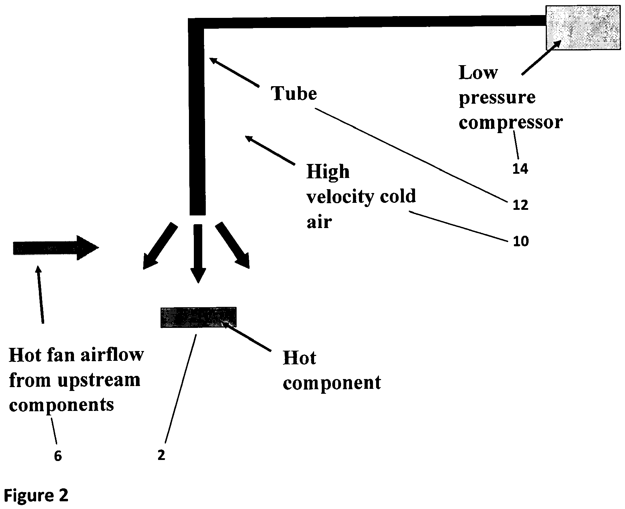

Figure 2 is an explanatory sketch similar to Figure 1 (similar parts are denoted by the same reference numerals). The heat sink of Figure 1 is removed completely and air jet 10 provides cooling directly to the component 2. This arrangement may be possible if the overall power dissipation of the components is reasonably small. This may considerably reduce costs, as a circuit pack may contain many heat sinks (sometimes greater than 10) and each heat sink may be of significant cost.

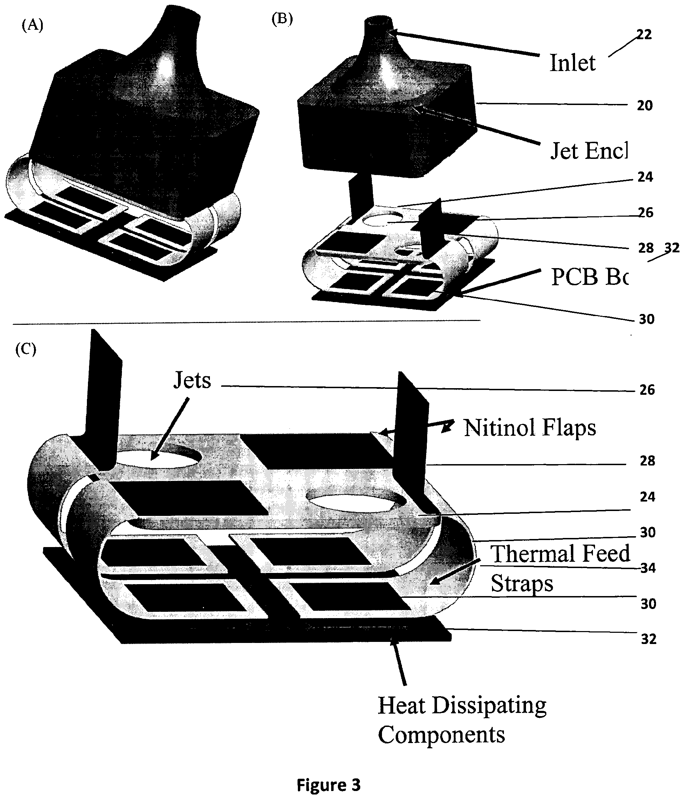

Referring to Figure 3, in some embodiments a Boolean jet array provides a manifold for distributing air, and incorporates thermal feedback for selectively closing outlet ports. A manifold housing 20 has an inlet 22 for a source of compressed air, and covers a rigid sheet 24 of thermally insulative material, which has four apertures 26 formed therein, which each provide a jet of air through the sheet. A Nitinol flap 28 is arranged to cover each respective aperture 26. Nitinol is a shape memory alloy of Ni and Ti. Shape-memory alloy, otherwise known as SMA, smart metal, memory metal, memory alloy, muscle wire, smart alloy, is an alloy that "remembers" its original, cold-forged shape: returning the pre-deformed shape by heating. Each flap and aperture is disposed directly above an electronic component or device 30 which is to be cooled. The devices 30 are mounted on a circuit pack 32. Each flap 28 is coupled by an arcuate thermally conductive feedback strap 34 to the respective device 30 directly beneath the strap.

In operation, at a low temperature of the devices 30, the flaps cover the apertures 26 and therefore prevent the flow of cooling air to the devices. As the temperature of a device 30 rises, this temperature is communicated by strap 34 to the respective flap 28. As the Nitinol heats up past its threshold temperature it reverts to a predefined, vertically upstanding shape, thus opening aperture 26 and allowing an air jet to cool the component. When the component is sufficiently cool and the temperature of the Nitinol drops below its threshold temperature the flap closes to switch off the cooling air jet. The shape of the Nitinol flap can be modified, and the threshold temperature for flap movement can also be altered as it relies on the physical make-up of the material. This thermal network configuration allows multiple component control without any additional electrical control, as it is completely passive. The open frame construction of the sheet 24 and straps 34 permit flow of fan cooling air if desired.

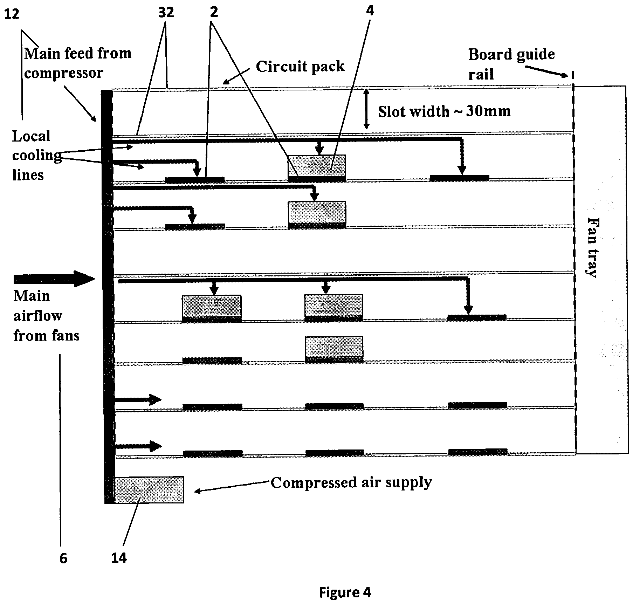

Figure 4 illustrates an example of a current rack and circuit pack set-up where a fan tray supplies airflow for cooling, similar parts to those of the preceding Figures being denoted by the same reference numeral. By employing the localized air cooling using compressed air and manifold arrangements as shown in Figure 3, we can provide adequate cooling for the hottest components under a range of different applications, e.g. direct air cooling over components with and without heat sinks or supplementary air cooling provided at the slot inlet as shown in Figure 4.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A thermal management apparatus for electronics and/or photonics equipment, the equipment comprising one or more circuit packs that include a plurality of devices that have different heating characteristics than other components of said one or more circuit packs,
the thermal management apparatus comprising a source of fluid, and a fluid distribution arrangement coupled to said source, and including a manifold having a fluid inlet and a plurality of outlets, each outlet providing a respective jet of fluid, such jets being directed towards at least one of said plurality of devices,
and wherein each said outlet has an associated closure means responsive to a change in temperature of one of said devices, said closure means being configured to switch said outlet between a closed position and an open position, in response to said change in temperature.

2. A thermal management apparatus according to claim 1, wherein each said outlet provides a respective jet, directed towards a respective one of said plurality of devices.

3. A thermal management apparatus according to claim 1 wherein each closure means comprises a flap, which is thermally coupled to the respective device, whereby in said closed position said flap covers the respective aperture, but in said open position, the flap is moved to uncover the respective aperture to permit flow of the respective jet.

4. A thermal management apparatus according to claim 3, wherein said outlets are formed as apertures in a plate, the flaps cover the apertures in said closed position, and said manifold includes a housing enclosing said plate

5. A thermal management apparatus according to claim 3 or 4, wherein each flap comprises a memory shape alloy.

6. A thermal management apparatus according to claim 5, wherein each flap is pre-stressed so that, with said change in temperature, the flap is upstanding from the plate and the respective aperture is uncovered.

7. A thermal management apparatus according to any preceding claim, wherein each said closure means derives energy for movement from heat conducted to the closure means from one of said devices.

8. A thermal management apparatus according to claim 7, wherein each closure means is coupled by a thermally conductive strap to a respective one of said devices.

9. A thermal management apparatus according to claim 8, wherein the straps are formed so as to hold a plate containing said aperture, spaced from said devices.

10. A thermal management apparatus according to any preceding claim, including fan means for blowing cooling fluid between said plate and said devices.

11. A thermal management apparatus according to any preceding claim, wherein at least one said device is mounted on a heat sink, and a respective said outlet is arranged so as to direct a respective jet of fluid at said heat sink.

12. A thermal management apparatus according to any preceding claim, wherein a single circuit pack includes a plurality of said devices.

13. A thermal management apparatus according to any preceding claim, wherein said equipment comprises arrays of circuit packs mounted in racks in a cabinet.

## Amended claims

### Amended claims in accordance with Rule 137(2) EPC.

**1.** A thermal management apparatus for electronics and/or photonics equipment, the equipment comprising one or more circuit packs (32) that include a plurality of devices (2, 30) that have different heating characteristics than other components of said one or more circuit packs,
the thermal management apparatus **characterized by** a source of compressed or pressurized fluid (14), and a fluid distribution arrangement coupled to said source, and including a manifold (20) having a fluid inlet (22) and a plurality of outlets (26), each outlet providing a respective jet (10) of fluid, such jets being directed over at least one of said plurality of devices,
and wherein each said outlet has an associated closure means (28) responsive to a change in temperature of one of said devices, said closure means being configured to switch said outlet between a closed position and an open position, in response to said change in temperature.

**2.** A thermal management apparatus according to claim 1, wherein each said outlet provides a respective jet, directed over a respective one of said plurality of devices.

**3.** A thermal management apparatus according to claim 1 wherein each closure means comprises a flap, which is thermally coupled (34) to the respective device, whereby in said closed position said flap covers the respective aperture, but in said open position, the flap is moved to uncover the respective aperture to permit flow of the respective jet.

**4.** A thermal management apparatus according to claim 3, wherein said outlets are formed as apertures in a plate (24), the flaps cover the apertures in said closed position, and said manifold includes a housing enclosing said plate

**5.** A thermal management apparatus according to claim 3 or 4, wherein each flap comprises a memory shape alloy.

**6.** A thermal management apparatus according to claim 5, wherein each flap is pre-stressed so that, with said change in temperature, the flap is upstanding from the plate and the respective aperture is uncovered.

**7.** A thermal management apparatus according to any preceding claim, wherein each said closure means derives energy for movement from heat conducted to the closure means from one of said devices.

**8.** A thermal management apparatus according to claim 7, wherein each closure means is coupled by a thermally conductive strap (34) to a respective one of said devices.

**9.** A thermal management apparatus according to claim 8, wherein the straps are formed so as to hold a plate (24) containing said aperture, spaced from said devices.

**10.** A thermal management apparatus according to any preceding claim, including fan means for blowing cooling fluid (6) between said plate and said devices.

**11.** A thermal management apparatus according to any preceding claim, wherein at least one said device is mounted on a heat sink (4), and a respective said outlet is arranged so as to direct a respective jet of fluid at said heat sink.

**12.** A thermal management apparatus according to any preceding claim, wherein a single circuit pack includes a plurality of said devices.

**13.** A thermal management apparatus according to any preceding claim, wherein said equipment comprises arrays of circuit packs mounted in racks in a cabinet.
